# EUROPEAN PATENT SPECIFICATION

(11) **EP 3 181 722 B1**
(45) Date of publication and mention of the grant of the patent: **18.04.2018**
(21) Application number: 16157778.8
(22) Date of filing: 29.02.2016
(51) Int. Cl.: C23C 16/44, C23C 16/442, C23C 16/455

(54) **PLANETARY ROTATION FLUIDIZED APPARATUS FOR NANOPARTICLE ATOMIC LAYER DEPOSITION**
FLUIDISIERTE VORRICHTUNG MIT PLANETARER ROTATION FÜR NANOPARTIKEL ZUR ATOMSCHICHTABSCHEIDUNG
APPAREIL FLUIDISÉ DE ROTATION PLANÉTAIRE POUR DÉPÔT DE COUCHE ATOMIQUE DE NANOPARTICULES

(30) Priority: 17.12.2015 CN 201510953058
(43) Date of publication of application: 21.06.2017
(73) Proprietor: Huazhong University of Science and Technology, Wuhan City Hubei 430074 (CN)
(72) Inventor: Chen, Rong, Wuhan, Hubei (CN); Zhu, Penghui, Wuhan, Hubei (CN); Duan, Chenlong, Wuhan, Hubei (CN); Shan, Bin, Wuhan, Hubei (CN); Ba, Weiming, Wuhan, Hubei (CN)
(74) Representative: Laufhütte, Dieter

(56) References cited:
- DD-A3- 246 011
- US-A1- 2006 062 902

## Description

### Technical Field

This invention belongs to the field of atomic layer deposition, and particularly relates to a device for nanoparticles' atomic layer decoration based on planetary fluidization.

### Background of the Invention

Compared with bulk materials, nanoparticles with large specific surface area and ultra-high surface energy have surface and quantum size effects, providing many unique chemical, physical, thermal, optical, electrical or biological properties. Since nanoparticles tends to agglomerate and are easy to be oxidized, the surface modification is required to overcome these weaknesses for practical usage in fields of functional ceramics, catalytic materials, optical detection, fuel cells, biomedicines, etc.

Several methods have been proposed to decorate nanoparticles with thin films. Liquid-phase based coating techniques are most commonly used, yet they usually suffer residue organic surfactants and complex steps for accurate thickness control. As a unique chemical vapor deposition approach, atomic layer deposition (ALD) based on self-limited chemisorption mechanism is able to deposit uniform and conformal nanoscale films onto high aspect ratio surfaces and afford precise thickness control at atomic scale. The challenge for particle surface modification using ALD is the large surface area and the non-uniform interstitials in the particle bed, which limit the diffusion of precursors and result in long cycle time and low precursor utilization. Therefore, special reactors and processes are needed. US2006/0062902 A1 discloses ALD on particles suspended by vibrations.

### Summary of the invention

In view of the above-mentioned problems, it is an objective of the invention to provide a device for nanoparticles' atomic layer decoration based on planetary fluidization. The radial centrifugal fluidization arising from rotation and revolution of particle cartridge increases the shear force to break the agglomerates apart and exposes more particles to precursors. Meanwhile, the axial vertical fluidization combining the planetary movement is capable of eliminating the non-uniform distribution of nanoparticles inside the cartridge, ensuring uniform and stable fluidization, which are beneficial for coating uniformity and saturation for large quantities of particles, as well as the process efficiency.

In order to achieve the above goals, this invention provides a device for nanoparticles' atomic layer deposition based on planetary fluidization, comprising a motor, a reaction chamber, a planet carrier, a cartridge, and a gas manifolds. the motor is connected to the planet carrier, a center wheel and multiple planet wheels are disposed on the planet carrier, the center wheel is disposed on a center line of the planet carrier with the center wheel, the cartridge and the planet wheel being installed onto the planet carrier, the center wheel is positioned on the same axis with the planet carrier, and engaged with the planet wheel, rotation of the center wheel and the planet wheel is driven by the motor; the cartridge is disposed in the reaction chamber, and operates to carry powder; the cartridge is connected to the planet wheel, and rotates with the planet wheel; the gas manifolds operate to inject reaction gas or carrier gas into the reaction chamber; a heating device is disposed between inner wall of the reaction chamber and outer wall thereof, and operates to heat the reaction chamber; and the reaction chamber is connected to a vacuum pump, and the vacuum pump operates to exhaust the air, precursor or byproduct gas inside the reaction chamber

A superior rotation speed ratio for the planet wheel to the center wheel is 1:2 to 2:1.

A rotation speed of the motor is 1 to 200 r/min.

A superior flow rate for the carrier gas into the reaction chamber is 10 sccm to 5 slm.

The planet carrier has a hollow structure, and the reaction gas or the carrier gas enters the cartridge from its bottom.

Each side of the cartridge is sealed by a 3000-mesh filter screen to prevent the leakage of nanoparticles.

The motor is connected to the planet carrier via a magnetic fluid seal device.

The cartridge and the hollow planet wheel are also connected by a magnetic fluid seal device.

The device also contains a lifting mechanism, which is connected to the cartridge to lift it out from the reaction chamber.

Advantages of the invention over the prior arts comprise:
1. The cartridge of the invention revolves around the center wheel, and spins with the planet wheel simultaneously. This planetary motion provides additional super-gravity for the nanoparticles during fluidization achieved by the fluidizing gas, which is supplied by the hollow planet carrier. The super-gravity can help to break the agglomerates apart, exposing more surfaces to precursors and improve the coating uniformity.
   Before decoration, the nanoparticles are firstly put into the cartridges, and then the cartridges are settled onto the hollow planet wheels. The planetary mechanism (including the planet carrier, the center wheel, the planet wheel and so on) in the reaction chamber drives the cartridge to conduct planetary motion. In the radial direction, the nanoparticles in the cartridge suffer the centrifugal force generated by the revolution, and therefore intend to move outwards and stack on the walls of the cartridges which locate on the connecting line from the revolution axis to spin axis. In the meantime, the circumferential friction force generated by the spin of the cartridges compels the nanoparticles to rotate inside the cartridge, achieving centrifugal fluidization. In the axis direction of the planet wheel, the nanoparticles are fluidized by the axial vertical fluidizing gas, and exhibit uniform fluidization as traditional vertical fluidized bed. The coupling of the centrifugal and vertical fluidization exerts shear force 30 times greater than gravity on the agglomerates, breaks them apart, and overcome the axial non-uniform distribution in centrifugal fluidized bed, realizing uniform fluidization of individual nanoparticles. During coating process, precursor gas and purge gas alternatively enter the cartridge through the planet carrier, and the precursor molecules are absorbed on the surface of the nanoparticles upon pulse stage, forming an atomic layer film.
2. The magnetic fluid seal device and its center shaft employ hollow structures (especially the one connecting the planet wheel to the planet carrier). The planet carrier is also hollow for the carrier gas or the reaction gas to pass through into the cartridge. Moreover, a pair of bearings is configured in the magnetic fluid seal device connected with the planet wheel, which ensures the revolution and rotation motion of the cartridge do not interfere with each other.
3. The rotation speed of the motor is 1 to 200 r/min, while the rotation speed ratio of the planet wheel to that of the center wheel is 1:2 to 2:1. The gas flow rate of the reaction gas or the carrier gas is 10 sccm to 5 slm, which ensures the nanoparticles in the cartridge can be perfectly fluidized for saturated atomic layer deposition on all surfaces. The invention is especially suitable for nanoscale particles (ranging from 10 nm to 1000 nm). In addition, sufficient dispersion of different sized particles are realized by adjusting the rotation speed using the motor and the fluidizing velocity.

To summarize, the device of the invention can effectively improve deposition ratio and uniformity, and significantly increase the coating efficiency with high batch processing ability.

### Brief description of accompanying drawings

FIG. 1 is a flowchart illustrating a deposition process using a device for nanoparticles' atomic layer decoration based on planetary fluidization;
FIG. 2 is a schematic view of a device for nanoparticles' atomic layer decoration based on planetary fluidization;
FIG. 3 illustrates operation principle of a device for nanoparticles' atomic layer decoration based on planetary fluidization;
FIG. 4 is a schematic view of a planetary fluidization mechanism of the invention; and
FIG. 5 is a schematic view of connection between a planet carrier and a cartridge base;
In which:
1- a device for nanoparticles' atomic layer decoration based on planetary fluidization; 2-motor; 3-magnetic fluid seal device; 4-mass flow controller; 5-stationary wheel; 6-cartridge; 7-vacuum pump; 8-center wheel; 9-planet wheel; 10-needle valve; 11-precursor source bottle; 12-lifting mechanism; 13-planet carrier; 14-cartridge base; 15-atomic layer deposition (ALD) diaphragm valve; 16-gate valve; 17-center shaft.

### Specific embodiments of the invention

For clear understanding of the objectives, features and advantages of the invention, detailed description of the invention will be given below in conjunction with accompanying drawings and specific embodiments. It should be noted that the embodiments are only meant to explain the invention, and not to limit the scope of the invention.

### Embodiment 1

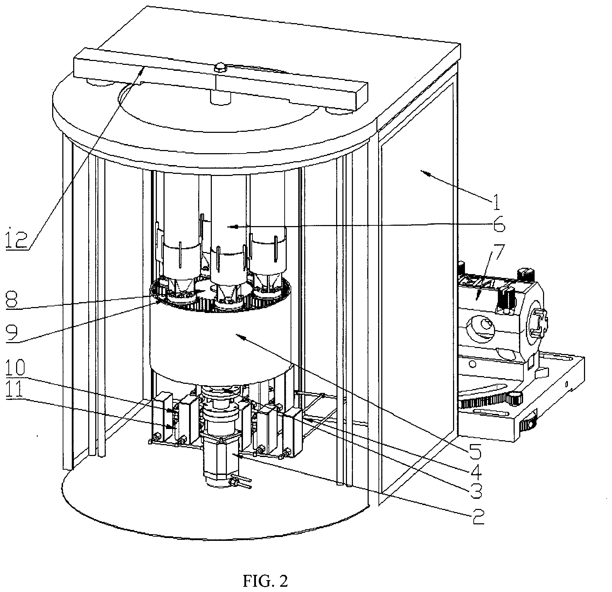

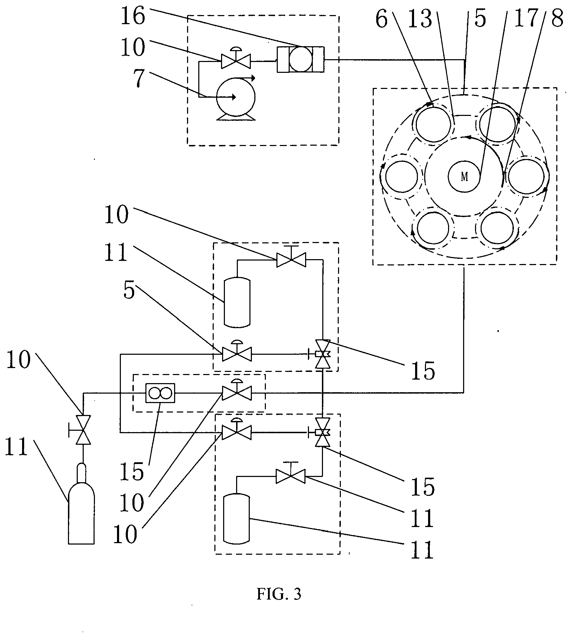

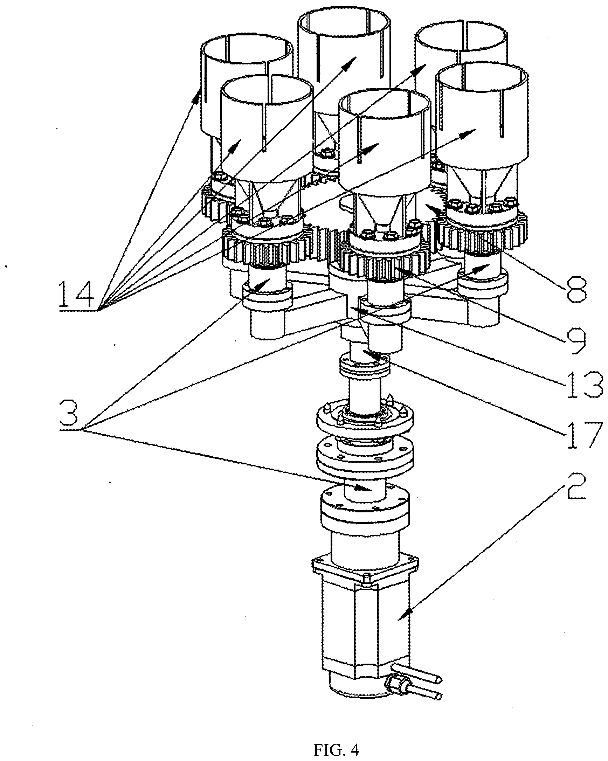

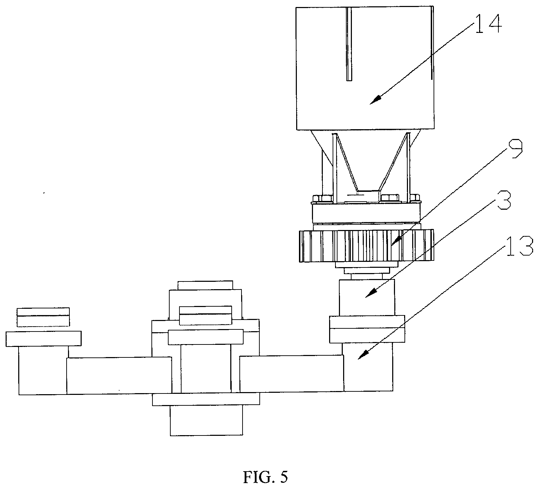

As shown in FIGS. 2 to 5, this invention provides a device for nanoparticles' atomic layer decoration based on planetary fluidization, comprising a motor 2, a reaction chamber, a planet carrier 13, a cartridge 6, and a gas manifolds.

The motor 2 is connected to the planet carrier 13, the center wheel 8 and multiple planet wheels 9 are disposed on the planet carrier 13, the center wheel 8 is disposed on a center line of the planet carrier 13 with the center wheel 8,the cartridge 6 and the planet wheel 9 being installed onto the planet carrier 13, the center wheel 8 is positioned on the same axis with the planet carrier 13, and engaged with the planet wheel 9, rotation of the center wheel 8 and the planet wheel 9 is driven by the motor 2; the cartridge 6 is disposed in the reaction chamber, and operates to carry powder; the cartridge 6 is connected to the planet wheel 9, and rotates with the planet wheel 9; the gas manifolds operate to inject reaction gas or carrier gas into the reaction chamber; a heating device is disposed between inner wall of the reaction chamber and outer wall thereof, and operates to heat the reaction chamber; and the reaction chamber is connected to a vacuum pump 7, and the vacuum pump 7 operates to exhaust the air, precursor or byproduct gas inside the reaction chamber.

The rotation speed ratio for the planet wheel 9 to the center wheel 8 is 1:2 to 2:1; the rotation speed of the motor 2 is 1 to 200 r/min; the flow rate for the carrier gas into the reaction chamber is 10 sccm to 5 slm; the planet carrier 13 has a hollow structure, and the reaction gas or the carrier gas enters the cartridge 6 from its bottom; a top end and a bottom end of the cartridge 6 are respectively sealed by a 3000-mesh filter screen to prevent leakage of nanoparticles.

The motor 2 is connected to the planet carrier 13 via a magnetic fluid seal device 3; the cartridge 6 and the hollow planet wheel 9 are connected via a magnetic fluid seal device 3.

The device further comprises a lifting mechanism 12 connected to the cartridge 6, and operating to lift the cartridge 6 out from the reaction chamber.

A flow controller for example, a mass flow controller 4 is configured on the gas manifolds. The center wheel engages with the planet wheel 9, and the planet wheel 9 engages with the stationary wheel. The motor 2 is installed to the outer wall of the reaction chamber via a magnetic fluid seal device. The planet carrier 13 and inner wall of the reaction chamber are also connected via a magnetic fluid seal device. The planet carrier matches with the center shaft 17 through a couple of bearings. The rotation of the center shaft 17 and the center wheel 8, which have the same angular velocity, is driven by the motor 2. The center wheel 8 drives the planet 9 and the planet carrier 13, ensuring their rotary movements do not interfere with each other.

### Embodiment 2

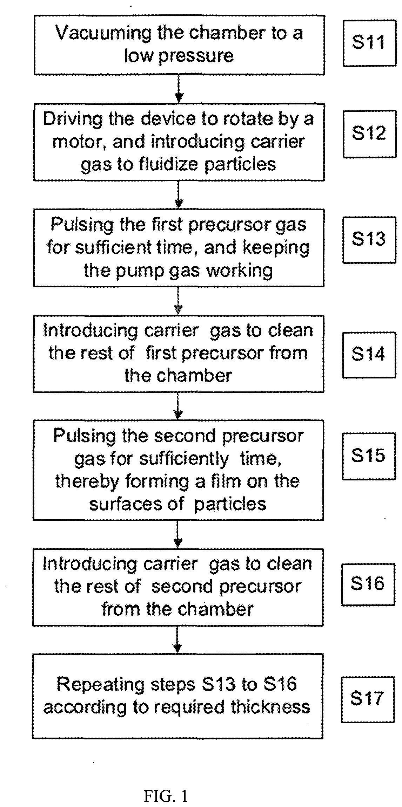

A flowchart to operate the device for nanoparticles' atomic layer decoration based on planetary fluidization is shown in FIG. 1:
S 11: putting nanoparticles into the cartridge and sealing both ends of the cartridge 6 with the 3000-mesh filter screen. Installing the cartridges 6 into the reaction chamber via the lifting mechanism. After closing the chamber cover, and starting the vacuum pump to exhaust the air until the pressure is below 1 Torr;
S12: starting the motor and adjusting the rotation speed to 1 to 200 rpm. Driving the planet wheel 9 and the planet carrier via the center wheel 8. The planetary motion is taken around the center of the planet carrier via the cartridge 6, while the nanoparticles inside the cartridge 6 begin to centrifugally fluidize under centrifugal force. Carrier gas ranging from 50 sccm to 5 slm and controlled by mass flow controllers entering the cartridge via the planet carrier, which fluidizes the nanoparticle bed. Starting the heating device with target temperature of the reaction chamber at 20 to 400°C. Ensuring the reaction temperature stabilize within ALD temperature window.
S 13: Opening the ALD diagram valve of the first precursor when the temperature reach and stabilize at the target value. Injecting the first precursor which is carried by the carrier gas into the chamber with the vacuum pump working. The precursor molecules absorb on particle surfaces during this stage. Maintaining the precursor injection a certain period of time to obtain saturated coverage.
S14: Switching off the ALD diagram valve of the first precursor after saturated growth. Continuing injecting the carrier gas for a period of time. Under the effect of vacuum pump and the carrier gas, the surplus first precursor and reaction byproduct are purged from the chamber;
S 15: Opening the ALD diagram valve of the second precursor when the temperature reach and stabilize at the target value. Inject the second precursor which is carried by the carrier gas into the chamber with the vacuum pump working. The precursor molecules react with surface sites of the first precursor molecules absorbed on particle surfaces. Maintaining the precursor injection a certain period of time to obtain saturated growth.
S16: Switching off the ALD diagram valve of the second precursor. Continuing injecting the carrier gas for a period of time. Under the effect of vacuum pump and the carrier gas, the surplus second precursor and reaction byproduct are purged from the chamber. A complete reaction cycle is finished;
S17: Repeating steps S 13 to S16 based on required film thickness.

In step S12, based on particle size and quality, the rotation speed of the cartridge (6) as well as the fluidizing velocity are adjusted to sufficiently disperse nanoparticles.

More than two kinds of precursors are feasible. By sequentially and alternatively introducing the precursor gases, a layer of coating film is formed surrounding the nanoparticles. Desired film thickness is obtained by repeating this procedure several times.

In this embodiment, the magnetic fluid seal device is a normal device to transfer rotation motion into a sealed chamber. It comprises a non-magnetic base, a bearing, a magnetic pole, a permanent magnet, a magnetic shaft, and magnetic fluid. The device of the invention further includes a control system and a detection system. The control system operates to control the conditions of the reaction chamber, such as pressure, temperature, flow rates, rotation speed, to meet requirements for the atomic layer deposition. The detection system operates to detect conditions that need to be controlled during reaction, and to form a feedback mechanism along with the control system. The control system can adjust the aforementioned conditions according to detected results. The carrier gas and the reaction gas can be introduced at the same time. By controlling gas flow rate of the carrier gas, it is possible to classify and disperse nanoparticles of different size and quality.

The types of nanoparticles and that of precursors are flexible, as long as the chemical absorption between the nanoparticles and the precursor gas can take place (reaction temperature can be adjusted as required). For example, the nanoparticles can be SiO₂, and the precursors can be trimethyl aluminium (TMA) and water. The particle size usually ranges from 10 nm to 1000 nm.

While preferred embodiments of the invention have been described above, the invention is not limited to disclosure in these embodiments and the accompanying drawings.

## Claims

1. A planetary rotation fluidized apparatus for nanoparticle atomic layer deposition, comprising a motor (2), a reaction chamber, a planet carrier (13), a cartridge (6), and multiple gas manifolds; wherein
said motor (2) is connected to said planet carrier (13), said center wheel (8) and multiple planet wheels (9) are disposed on said planet carrier (13), said center wheel (8) is disposed on a center line of said planet carrier (13) with said center wheel (8),said cartridge (6) and said planet wheel (9) being installed onto said planet carrier (13), said center wheel (8) is positioned on the same axis with said planet carrier (13), and engaged with said planet wheel (9), rotation of said center wheel (8) and said planet wheel (9) is driven by said motor (2);
said cartridge (6) is disposed in said reaction chamber, and operates to carry powder;
said cartridge (6) is connected to said planet wheel (9), and rotates with said planet wheel (9);
said gas manifolds operate to inject reaction gas or carrier gas into said reaction chamber;
a heating device is disposed between inner wall of said reaction chamber and outer wall thereof, and operates to heat said reaction chamber; and
said reaction chamber is connected to a vacuum pump (7), and said vacuum pump (7) operates to exhaust the air, precursor or byproduct gas inside said reaction chamber.

2. The device for nanoparticles' atomic layer deposition based on planetary fluidization of claim 1, wherein a rotation speed ratio of said planet wheel (9) to that of said center wheel (8) is 1:2 to 2:1.

3. The device for nanoparticles' atomic layer deposition based on planetary fluidization of claim 1, wherein a rotation speed of said motor (2) is 1 to 200 r/min.

4. The device for nanoparticles' atomic layer deposition based on planetary fluidization of claim 1, wherein a superior flow rate of said carrier gas injected into said reaction chamber is 10 sccm to 5 slm.

5. The device for nanoparticles' atomic layer deposition based on planetary fluidization of claim 1, wherein said planet carrier (13) has a hollow structure, and said reaction gas or said carrier gas enters said cartridge (6) from the bottom thereof.

6. The device for nanoparticles' atomic layer deposition based on planetary fluidization of claim 1, wherein a top end and a bottom end of said cartridge (6) are respectively sealed by a 3000-mesh filter screen to prevent leakage of nanoparticles.

7. The device for nanoparticles' atomic layer deposition based on planetary fluidization of claim 1, wherein said motor (2) is connected to said planet carrier (13) via a magnetic fluid seal device (3).

8. The device for nanoparticles' atomic layer deposition based on planetary fluidization of claim 7, further comprising a pair of bearings disposed in said magnetic fluid seal device connected to said planet wheel (9),

9. The device for nanoparticles' atomic layer deposition based on planetary fluidization of claim 1, wherein said cartridge (6) and said hollow planet wheel (9) are connected via a magnetic fluid seal device (3).

10. The device for nanoparticles' atomic layer deposition based on planetary fluidization of anyone claims 1 to 9, further comprising a lifting mechanism (12) connected to said cartridge (6), and operating to lift said cartridge (6) out from said reaction chamber.

## Patentansprüche

1. Fluidisierte Einrichtung mit planetarer Rotation für Nanopartikel-Atomlagenabscheidung, welche einen Motor (2), eine Reaktionskammer, einen Planetenträger (13), eine Patrone (6) und mehrere Gassammelrohre umfasst; wobei
der Motor (2) mit dem Planetenträger (13) verbunden ist, das mittige Rad (8) und mehrere Planetenräder (9) an dem Planetenträger (13) angeordnet sind, das mittige Rad (8) an einer Mittellinie des Planetenträgers (13) angeordnet ist, wobei das mittige Rad (8), die Patrone (6) und das Planetenrad (9) an dem Planetenträger (13) angebracht sind, das mittige Rad (8) an der gleichen Achse mit dem Planetenträger (13) positioniert ist und mit dem Planetenrad (9) in Eingriff steht, Drehung des mittigen Rads (8) und des Planetenrads (9) von dem Motor (2) angetrieben wird;
die Patrone (6) in der Reaktionskammer angeordnet ist und zum Aufnehmen von Pulver dient;
die Patrone (6) mit dem Planetenrad (9) verbunden ist und mit dem Planetenrad (9) dreht;
die Gassammelrohre zum Einspritzen von Reaktionsgas oder Trägergas in die Reaktionskammer dienen;
eine Heizvorrichtung zwischen Innenwand der Reaktionskammer und Außenwand derselben angeordnet ist und zum Erwärmen der Reaktionskammer dient; und
die Reaktionskammer mit einer Vakuumpumpe (7) verbunden ist und die Vakuumpumpe (7) zum Ablassen der Luft, von Vorläufer- oder Nebenproduktgas in der Reaktionskammer dient.

2. Vorrichtung für Nanopartikel-Atomlagenabscheidung beruhend auf planetarer Fluidisierung nach Anspruch 1, wobei ein Drehzahlverhältnis des Planetenrads (9) zu dem des mittigen Rads (8) bei 1:2 bis 2:1 liegt.

3. Vorrichtung für Nanopartikel-Atomlagenabscheidung beruhend auf planetarer Fluidisierung nach Anspruch 1, wobei eine Drehzahl des Motors (2) 1 bis 200 U/min. beträgt.

4. Vorrichtung für Nanopartikel-Atomlagenabscheidung beruhend auf planetarer Fluidisierung nach Anspruch 1, wobei ein ausgezeichneter Durchsatz des in die Reaktionskammer eingespritzten Trägergases 10 sccm bis 5 slm beträgt.

5. Vorrichtung für Nanopartikel-Atomlagenabscheidung beruhend auf planetarer Fluidisierung nach Anspruch 1, wobei der Planetenträger (13) eine hohle Struktur aufweist und das Reaktionsgas oder das Trägergas in die Patrone (6) von dem Boden derselben eindringt.

6. Vorrichtung für Nanopartikel-Atomlagenabscheidung beruhend auf planetarer Fluidisierung nach Anspruch 1, wobei ein oberes Ende und ein unteres Ende der Patrone (6) jeweils durch ein Filtersieb mit einer Maschenweite von 3000 abgedichtet sind, um ein Austreten von Nanopartikeln zu verhindern.

7. Vorrichtung für Nanopartikel-Atomlagenabscheidung beruhend auf planetarer Fluidisierung nach Anspruch 1, wobei der Motor (2) mittels einer magnetischen Fluiddichtungsvorrichtung (3) mit dem Planetenträger (13) verbunden ist.

8. Vorrichtung für Nanopartikel-Atomlagenabscheidung beruhend auf planetarer Fluidisierung nach Anspruch 7, welche weiterhin ein Paar von Lagern umfasst, die in der magnetischen Fluiddichtungsvorrichtung angeordnet sind, welche mit dem Planetenrad (9) verbunden ist.

9. Vorrichtung für Nanopartikel-Atomlagenabscheidung beruhend auf planetarer Fluidisierung nach Anspruch 1, wobei die Patrone (6) und das hohle Planetenrad (9) mittels einer magnetischen Fluiddichtungsvorrichtung (3) verbunden sind.

10. Vorrichtung für Nanopartikel-Atomlagenabscheidung beruhend auf planetarer Fluidisierung nach einem der Ansprüche 1 bis 9, welche weiterhin einen Hubmechanismus (12) umfasst, der mit der Patrone (6) verbunden ist und dazu dient, die Patrone (6) aus der Reaktionskammer heraus zu heben.

## Revendications

1. Appareil fluidisé de rotation planétaire pour dépôt de couche atomique de nanoparticules, comprenant un moteur (2), une chambre de réaction, un porte-satellites (13), une cartouche (6), et plusieurs collecteurs de gaz ; dans lequel
ledit moteur (2) est relié audit porte-satellites (13), lesdites roue centrale (8) et plusieurs roues planétaires (9) sont disposées sur ledit porte-satellites (13), ladite roue centrale (8) est disposée sur une ligne centrale dudit porte-satellites (13), ladite roue centrale (8), ladite cartouche (6) et ladite roue planétaire (9) étant installées sur ledit porte-satellites (13), ladite roue centrale (8) est positionnée sur le même axe que ledit porte-satellites (13), et en prise avec ladite roue planétaire (9), une rotation de ladite roue centrale (8) et ladite roue planétaire (9) est entraînée par ledit moteur (2) ;
ladite cartouche (6) est disposée dans ladite chambre de réaction, et sert à transporter de la poudre ;
ladite cartouche (6) est reliée à ladite roue planétaire (9), et tourne avec ladite roue planétaire (9) ;
lesdits collecteurs de gaz servent à injecter du gaz de réaction ou du gaz porteur dans ladite chambre de réaction ;
un dispositif de chauffage est disposé entre une paroi intérieure de ladite chambre de réaction et une paroi extérieure de celle-ci, et sert à chauffer ladite chambre de réaction ; et
ladite chambre de réaction est reliée à une pompe à vide (7), et ladite pompe à vide (7) sert à évacuer l'air, le gaz précurseur ou le sous-produit gazeux se trouvant à l'intérieur de ladite chambre de réaction.

2. Dispositif de dépôt de couche atomique de nanoparticules sur la base de la fluidisation planétaire selon la revendication 1, dans lequel un rapport entre la vitesse de rotation de ladite roue planétaire (9) et celle de ladite roue centrale (8) est de 1:2 à 2:1.

3. Dispositif de dépôt de couche atomique de nanoparticules sur la base de la fluidisation planétaire selon la revendication 1, dans lequel une vitesse de rotation dudit moteur (2) est de 1 à 200 tr/min.

4. Dispositif de dépôt de couche atomique de nanoparticules sur la base de la fluidisation planétaire selon la revendication 1, dans lequel un débit supérieur dudit gaz porteur injecté dans ladite chambre de réaction est de 10 sccm à 5 slm.

5. Dispositif de dépôt de couche atomique de nanoparticules sur la base de la fluidisation planétaire selon la revendication 1, dans lequel ledit porte-satellites (13) comporte une structure creuse, et ledit gaz de réaction ou ledit gaz porteur pénètre dans ladite cartouche (6) par le bas de celle-ci.

6. Dispositif de dépôt de couche atomique de nanoparticules sur la base de la fluidisation planétaire selon la revendication 1, dans lequel une extrémité supérieure et une extrémité inférieure de ladite cartouche (6) sont respectivement fermées de manière étanche par un tamis filtrant de 3000 mesh afin d'empêcher une fuite de nanoparticules.

7. Dispositif de dépôt de couche atomique de nanoparticules sur la base de la fluidisation planétaire selon la revendication 1, dans lequel ledit moteur (2) est relié audit porte-satellites (13) par le biais d'un dispositif d'étanchéité à ferrofluide (3).

8. Dispositif de dépôt de couche atomique de nanoparticules sur la base de la fluidisation planétaire selon la revendication 7, comprenant en outre une paire de paliers disposée dans ledit dispositif d'étanchéité à ferrofluide relié à ladite roue planétaire (9).

9. Dispositif de dépôt de couche atomique de nanoparticules sur la base de la fluidisation planétaire selon la revendication 1, dans lequel ladite cartouche (6) et ladite roue planétaire creuse (9) sont reliées par le biais d'un dispositif d'étanchéité à ferrofluide (3).

10. Dispositif de dépôt de couche atomique de nanoparticules sur la base de la fluidisation planétaire selon l'une quelconque des revendications 1 à 9, comprenant en outre un mécanisme de levage (12) relié à ladite cartouche (6), et servant à lever ladite cartouche (6) hors de ladite chambre de réaction.
